# EUROPÄISCHE PATENTSCHRIFT

(11) **EP 0 489 958 B1**
(45) Veröffentlichungstag und Bekanntmachung des Hinweises auf die Patenterteilung: **16.03.1994**
(21) Anmeldenummer: 90123945.9
(22) Anmeldetag: 12.12.1990
(51) Int. Cl.: H05K 7/20, H05K 1/02, H01L 23/40

(54) **Leiterplatte für elektronische Steuergeräte und Verfahren zum Herstellen einer solchen Leiterplatte**
Circuit board for electronic control apparatus and method of making this circuit board
Plaquette de circuit pour appareillage électronique de contrôle et procédé de fabrication d'une telle plaquette

(43) Veröffentlichungstag der Anmeldung: 17.06.1992
(73) Patentinhaber: SIEMENS AKTIENGESELLSCHAFT, 80333 München (DE)
(72) Erfinder: Nett, Walter, W-8411 Laaber/Polzhausen (DE)

(56) Entgegenhaltungen:
- EP-A- 0 291 400
- DE-A- 3 631 963
- DE-A- 3 833 146
- FR-A- 2 413 016
- US-A- 4 756 081
- PATENT ABSTRACTS OF JAPAN vol. 9, no. 251 (E-348)(1974) 8. Oktober 1985 & JP-A-60 100 457

## Beschreibung

Die Erfindung betrifft eine Leiterplatte für ein elektronisches Steuergerät, die mit mindestens einem Bauelement versehen ist, das auf der Leiterplatte befestigt ist.

Insbesondere bei elektrischen und elektronischen Geräten, die in Kraftfahrzeugen verwendet werden, ist es wegen der starken Erschütterungen, denen diese Geräte im Betrieb unterliegen, wichtig, die Anschlußbeinchen der einzelnen Bauteile möglichst mechanisch spannungsfrei zu verlöten. Dadurch werden erhöhte Übergangswiderstände und Unterbrechungen durch Brüche von Lötstellen verhindert. Bekannt ist es, zuerst das Bauteil an einem Träger zu befestigen und dann die Leiterplatte mit ihren Bohrungen auf die Anschlußleiter aufzulegen und zu befestigen, wobei die Anschlußleiter durch die Bohrungen ragen, und danach die Lötverbindungen der Enden aller Anschlußleiter mit den Leiterbahnen herzustellen (DE-OS 38 33 146).

Die Leiterplatte einer bekannten Flachbaugruppe (DE-OS 36 31 963) weist Ausbruchelemente auf, über denen Bauelemente angeordnet sind. Die Bauelemente werden mit der Leiterplatte verlötet, bevor die Ausbruchelemente entfernt werden. Nach dem Entfernen entstehen Aussparung der Leiterplatte, in die von der Lötseite her ein Kühlkörper eingesteckt und an der Leiterplatte befestigt wird. Auf einem Kühlkörper sind mehrere Bauelemente angeordnet. Zur besseren Wärmeabfuhr werden die Bauelemente und der Kühlkörper miteinander verschraubt.

Ein bekanntes Leistungsmodul (EP-A 0 291 400) weist einen Kühlkörper auf, der auf der den Bauelementen gegenüberliegenden Seite einer Leiterplatte befestigt ist. Ein Bauelement ist vollständig in einer Aussparung der Leiterplatte der Kühlplatte angeordnet. Das Bauelement ist über Bonddrähte elektrisch mit der Leiterplatte verbunden.

Diese bekannten Leiterplatten sind nicht für den rauhen Betrieb und den Einsatz in einem Kraftfahrzeug geeignet, da die Bauelemente nicht form- und kraftschlüssig mit der Leiterplatte verbunden sind.

Der Erfindung liegt die Aufgabe zugrunde, eine Leiterplatte zu schaffen, die einfach herzustellen ist und die widerstandsfähig gegen rauhen Betrieb ist.

Diese Aufgabe wird durch eine Leiterplatte nach Anspruch 1 und das Verfahren nach Anspruch 4 gelöst.

Vorteilhafte Weiterbildungen der Erfindung sind den Unteransprüchen zu entnehmen.

Die Vorteile der Erfindung liegen unter anderem darin, daß die Leiterplatte geeignet ist, in großen Stückzahlen kostengünstig hergestellt zu werden und daß sie die in den auf ihr angeordneten Bauteilen, insbesondere Leistungsbauteilen, erzeugte Gesamtwärme gut abführt. Die Gefahr von Beschädigungen der Bauteile durch Wärmespitzen wird gemildert. Belastungen der Lötstellen bei der Montage der Bauteilen werden verhindert. Ebenso eine Belastung der Lötstellen bei dem Transport und dem Einbau der gesamten Baugruppe. Außerdem ist es nun möglich, die bestückte Leiterplatte im Tauchbad allseitig zu lackieren.

Ein Ausführungsbeispiel der Erfindung wird im folgenden anhand der Zeichnung erläutert. Es zeigen:
- Figur 1: eine in ein Gehäuse eingefügte Leiterplatte gemäß der Erfindung, in einer Teilansicht im Schnitt und
- Figur 2: die Leiterplatte nach Figur 1 in der Draufsicht.

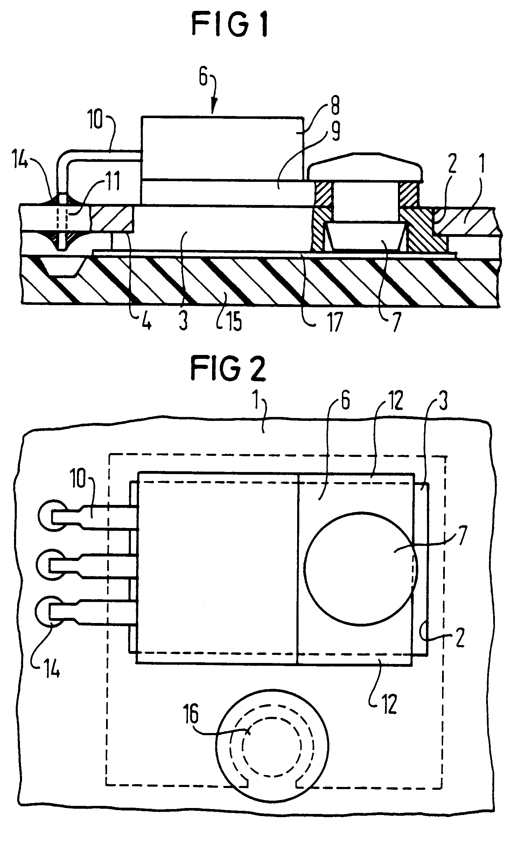

Eine Leiterplatte 1 weist eine Aussparung 2 auf, in die von der Lötseite her - in der Zeichnung von unten her - eine gut wärmeleitende Platte 3, z.B. eine Metallplatte, eingesetzt wird (Figur 1 und 2). Die Platte 3 weist einen Rand oder Absatz 4 auf, durch den ihre Lage auch in senkrechter Richtung fixiert wird.

Auf die als Wärmesenke dienende Platte 3 wird - von der Bauteileseite der Leiterplatte 1 her - ohne dazwischenliegende Isolierung ein Bauteil 6, z.B. ein Leistungsbauteil, aufgesetzt und mit einer Niete 7 befestigt. Die Befestigung kann naturgemäß auch auf andere Art erfolgen, z.B. durch eine Schraub- oder Klebeverbindung. Das Bauteil 6 weist ein, z.B. aus Kunststoff hergestelltes, Gehäuse 8 und eine metallische Grundplatte 9 auf. Wegen der unmittelbaren breitflächigen Auflage der Grundplatte 9 auf der Platte 3 wird ein sehr guter Wärmeübergang erreicht.

Das Bauteil 6 weist Anschlußbeinchen oder -fahnen 10 auf, die durch eine metallisierte Bohrung 11 in der Leiterplatte 1 hindurchgesteckt und verlötet werden. Damit wird das Bauteil 6 mit - in der Zeichnung nicht dargestellten - Leiterbahnen auf der Leiterplatte 1 elektrisch verbunden.

Die Grundplatte 9 des Bauteiles 6 ist breiter als die Aussparung 2, das Bauteil 6 liegt somit mit zwei seitlichen Randstreifen 12 (Figur 2) auf der Leiterplatte 1 auf. Durch den Absatz 4, die beiden Randstreifen 12 und die Niete 7 ergibt sich eine form- und kraftschlüssige Verbindung des Bauteils 6 mit der Leiterplatte 1, die die Lage des Bauteils fixiert. Die Anschlußfahnen 10 können gelötet werden, ohne mechanisch beansprucht zu sein. Die dabei gebildeten Lötstellen 14 sind somit spannungsfrei und nicht bruchgefährdet. Sie werden auch bei den folgenden Arbeitsgängen, wie z.B. das Prüfen, Lackieren und Transportieren der Leiterplatte 1 oder der gesamten Baugruppe nicht mehr belastet.

Die mit Baugruppen 6 bestückte Leiterplatte 1 wird in ein Gehäuse 15 eingesetzt und an diesem mit einer Niete, Schraube 16 oder dergleichen befestigt. Dabei wird zwischen die gut wärmeleitende Platte 3 und das Gehäuse 15 eine Isolierfolie 17 eingelegt.

Die Platte 3 ist entsprechend dem jeweiligen Kühlbedarf ausreichend groß dimensioniert. Da sie großflächig auf das Gehäuse gepreßt wird, ergibt sich auch hier ein guter Wärmeübergang und damit eine gute Wärmeabfuhr über das Gehäuse.

Mit der vorstehend beschriebenen Leiterplatte 1 ist es inbesondere möglich, Leistungsbauteile flachliegend auf ihr zu montieren und trotzdem strenge Anforderungen an Wärmeabfuhr und Widerstandsfähigkeit gegen Erschütterungen und sonstige Beanspruchungen im rauhen Betrieb zu erfüllen.

## Patentansprüche

1. Leiterplatte für ein elektronisches Steuergerät, die mit mindestens einem Bauelement (6) versehen ist, das auf der Leiterplatte (1) befestigt ist, wobei
- die Leiterplatte (1) eine Aussparung (2) aufweist, in die die Vorderseite einer gut wärmeleitenden Platte (3) eingesetzt ist, die rückseitig die Aussparung mit einem Rand (4) übergreift;
- die Grundplatte (9) des Bauelements (6) breiter ist als die Aussparung (2) und mit zwei Randstreifen (12) auf der Leiterplatte (1) im Bereich der Aussparung (2) aufliegt und
- das Bauelement (6) auf der Vorderseite der Platte (3) befestigt ist, so daß die Leiterplatte (1) zwischen dem Rand (4) und den Randstreifen (12) eingeklemmmt und somit die Lage des Bauelements (6) fixiert ist.

2. Leiterplatte nach Anspruch 1, dadurch gekennzeichnet, daß das Bauteil (6) mit der Leiterplatte (1) vernietet, verschraubt oder verklebt ist.

3. Leiterplatte nach Anspruch 1, dadurch gekennzeichnet, daß sie in ein Gehäuse (15) eingesetzt und an einer Gehäusewand befestigt ist, wobei zwischen der Gehäusewand und der wärmeleitenden Platte (3) eine Isolierfolie (17) eingefügt ist.

4. Verfahren zum Herstellen einer Leiterplatte nach einem der Ansprüche 1 bis 3, das aus folgenden Schritten besteht:
- eine gut wärmeleitende Platte wird von der Lötseite der Leiterplatte her in eine Aussparung in der Leiterplatte eingesteckt, bis sie mit einem Rand an der Leiterplatte anliegt,
- ein Bauelement wird auf die wärmeleitende Platte aufgesetzt und mit dieser formschlüssig so verbunden, daß es auf der Leiterplatte in ihrer Lage fixiert ist, und
- anschließend werden die Anschlußleiter des Bauteils mit Kontaktierungsbohrungen in der Leiterplatte verlötet.

5. Verfahren nach Anspruch 4, dadurch gekennzeichnet, daß die mit Bauelementen bestückte Leiterplatte unter Zwischenlage eine Isolierfolie in einem Gehäuse befestigt wird.

## Claims

1. Printed circuit board for an electronic control apparatus, which is provided with at least one component (6) mounted on the printed circuit board (1),
- the printed circuit board (1) having a cutout (2) into which the front of a plate (3) which has good thermal conductivity and an edge (4) of which engages over the cutout at the back is inserted,
- the base plate (9) of the component (6) being wider than the cutout (2) and resting on the printed circuit board (1) by means of two edge strips (12) in the region of the cutout (2), and
- the component (6) being mounted on the front of the plate (3) so that the printed circuit board (1) is clamped between the edge (4) and the edge strips (12) and the position of the component (6) is consequently fixed.

2. Printed circuit board according to Claim 1, characterized in that the component (6) is riveted, screwed or bonded to the printed circuit board (1).

3. Printed circuit board according to Claim 1, characterized in that it is inserted into a housing (15) and is attached to a housing wall, an insulating film (17) being inserted between the housing wall and the thermally conducting plate (3).

4. Method for producing a printed circuit board according to one of Claims 1 to 4, which comprises the following steps:
- a plate with good thermal conductivity is inserted into a cutout in the printed circuit board from the solder side of the printed circuit board until it rests by means of an edge on the printed circuit board,
- a component is placed on the thermally conducting plate and joined to it in an interlocking manner so that the position of the component on the printed circuit board is fixed, and
- the connecting leads of the component are then soldered to the contacting holes in the printed circuit board.

5. Method according to Claim 5, characterized in that the printed circuit board fitted with components is mounted in a housing with the interposition of an insulating film.

## Revendications

1. Plaquette à circuits imprimés d'un appareil électronique de commande, qui est munie d'au moins un composant (6) fixé à la plaquette à circuits imprimés (1) et dans laquelle
- la plaquette à circuits imprimés (1) comporte un évidement (2) dans lequel est insérée la face avant d'une plaque (3) conductrice de la chaleur, qui s'accroche par un bord (4) sur le côté arrière de l'évidement;
- la plaque de base (9) du composant (6) est plus large que l'évidement (2) et s'applique par deux bandes marginales (12) sur la plaquette à circuits imprimés (1) dans la région de l'évidement (2), et
- le composant (6) est fixé sur la face avant de la plaque (3) de sorte que la plaquette à circuits imprimés (1) soit serrée entre le bord (4) et les bandes marginales (12) et que par conséquent le composant (6) soit fixé en position.

2. Plaquette à circuits imprimés suivant la revendication 1, caractérisée par le fait que le composant (6) est riveté, vissé ou collé à la plaquette à circuits imprimés (1).

3. Plaquette à circuits imprimés suivant la revendication 1, caractérisée par le fait qu'elle est insérée dans un boîtier (15) et est fixée sur une paroi du boîtier, une feuille isolante (17) étant insérée entre la paroi du boitier et la plaquette (3) conduisant à la chaleur (3).

4. Procédé pour fabriquer une plaquette à circuits imprimés suivant l'une des revendications 1 à 4, qui comprend les étapes suivantes :
- on met une plaque conduisant la chaleur, à partir du côté de brasage de la plaquette à circuits imprimés, dans un évidement ménagé dans cette plaquette jusqu'à ce que la plaque s'applique par un bord sur la plaquette à circuits imprimés,
- on place un composant sur la plaque conduisant la chaleur et on la relie à cette dernière selon une liaison par formes complémentaires de manière à la fixer en position sur la plaquette à circuits imprimés, et
- on fixe ensuite les conducteurs de raccordement du composant par brasage aux trous de contact ménagés dans la plaquette à circuits imprimés.

5. Procédé suivant la revendication 4, caractérisé par le fait qu'on fixe la plaquette à circuits imprimés munie des composants, dans un boîtier, avec interposition d'une feuille isolante.
